# EUROPÄISCHE PATENTSCHRIFT

(11) **EP 2 848 103 B1**
(45) Veröffentlichungstag und Bekanntmachung des Hinweises auf die Patenterteilung: **01.02.2017**
(21) Anmeldenummer: 13717717.6
(22) Anmeldetag: 16.04.2013
(51) Int. Cl.: H05K 7/20

(54) **ELEKTROGERÄT MIT GEHÄUSETEIL**
ELECTRIC APPLIANCE WITH HOUSING PART
APPAREIL ÉLECTRIQUE COMPRENANT UNE PARTIE BOÎTIER

(30) Priorität: 08.05.2012 DE 102012008897
(43) Veröffentlichungstag der Anmeldung: 18.03.2015
(73) Patentinhaber: Sew-Eurodrive GmbH & Co. KG, 76646 Bruchsal (DE)
(72) Erfinder: KRATTENMACHER, Hans, 75015 Bretten (DE); MAYER, Ralph, 76698 Ubstadt-Weiher (DE); DAMINGER, Franz, 67067 Ludwigshafen am Rhein (DE)
(86) Internationale Anmeldenummer: PCT/EP2013/001112
(87) Internationale Veröffentlichungsnummer: WO 2013/167227

(56) Entgegenhaltungen:
- EP-A1- 1 109 432
- US-A- 6 065 530

## Beschreibung

Die Erfindung betrifft ein Elektrogerät mit Gehäuseteil.

Es ist allgemein bekannt, dass Wärmeerzeugende Bauteile mit Kühlkörpern verbunden werden, um die von den Bauteilen erzeugte Wärme an die Umgebung abzuführen.

**Aus der** EP 1 109 432 A1 **ist eine Wärmedissipationsanordnung für ein elektrisches Gerät bekannt, bei der von einer Wärme erzeugenden Komponente aus gesehen strahlenförmig angeordnete Schlitze in einem Gehäuseteil vorgesehen sind.**

Der Erfindung liegt daher die Aufgabe zugrunde, ein Elektrogerät mit Gehäuseteil weiterzubilden, wobei eine verbesserte Entwärmung erreichbar sein soll.

Erfindungsgemäß wird die Aufgabe bei dem Elektrogerät mit Gehäuseteil nach den in Anspruch 1 angegebenen Merkmalen gelöst.

Wichtige Merkmale der Erfindung bei dem Elektrogerät mit Gehäuseteil sind, dass ein wärmeerzeugendes Bauteil an einem Oberflächenabschnitt der Innenseite des Gehäuseteils angeordnet ist, insbesondere wärmeleitend verbunden ist,
**wobei** an der Innenseite des Gehäuseteils herausragende Stege ausgeformt sind,
wobei die Stege vom Oberflächenabschnitt ausgehend sich an der Innenseite des Gehäuseteils erstrecken,
insbesondere wobei die Stege in den vom Gehäuseteil zumindest teilweise abgedeckten Innenraumbereich des Elektrogeräts hineinragen.

Von Vorteil ist dabei, dass die am Oberflächenabschnitt" also am Kontaktflächenbereich, ein sehr hoher Wärmestrom eingetragen wird und somit eine sehr hohe Temperatur herrscht. Durch die Stege ist eine schnelle Aufspreizung der an dem an der Innenseite des Gehäuseteils eingetragenen Wärme ermöglicht. Denn der Oberflächenabschnitt ist domartig herausragend an der Innenseite ausgeformt. Die Stege erstrecken sich ausgehend vom Oberflächenabschnitt strahlenförmig weg. Auf diese Weise ist ein schnelles Ausbreiten der Wärme weg vom Oberflächenabschnitt einfach und schnell erreichbar. Dabei sind Stege und Dom sowie Kühlrippen oder Kühlfinger einstückig am Gehäuseteil ausgeformt. Der aufgespreizte Wärmestrom durchdringt von den Stegen aus durch die Gehäusewandung des Gehäuseteils zu den an der Außenseite angeformten Kühlrippen oder Kühlfingern, wo dann schon viel tiefere Temperaturen auftreten.

Von Vorteil ist bei der Verwendung von Stegen, dass beim Herstellen des Gehäuseteils durch Guss die Lunkerbildung verminderbar oder verhinderbar ist.

Bei einer vorteilhaften Ausgestaltung weist das Gehäuseteil an seiner Außenseite Kühlrippen und/oder Kühlfinger, auf. Von Vorteil ist dabei, dass eine Oberflächenvergrößerung eine verbesserte Entwärmung erreichbar macht.

Bei einer vorteilhaften Ausgestaltung ragt der Oberflächenabschnitt an der Innenseite des Gehäuseteils heraus. Von Vorteil ist dabei, dass der Oberflächenabschnitt domartig in den Innenraumbereich hervorsteht, insbesondere genauso weit wie die Stege. Somit ist ein hoher Wärmestrom in die Stege einleitbar. Außerdem ist die Wandstärke im Beriech des Oberflächenabschnitts verdickt und somit eine große Wärmekapazität vorhanden, welche Wärmestromspitzen abzupuffern vermag.

Bei einer vorteilhaften Ausgestaltung sind als Stege Radialstege und Querstege vorhanden, wobei die Radialstege in radialer Richtung von einer Geraden aus, welche in Normalenrichtung des Oberflächenabschnitts an einem Punkt des Oberflächenabschnitts ausgerichtet ist,

insbesondere wobei die Querstege in Umfangsrichtung verlaufen, also einen vom Umfangswinkel unabhängigen Radialabstand aufweisen. Von Vorteil ist dabei, dass durch die sternstrahlenartig angeordneten Radialstege ein hoher Wärmestrom möglichst schnell weg vom Oberflächenabschnitt leitbar ist. Durch die Querstege ist ein noch weiter verbessertes Aufspreizen der Wärme ermöglicht.

Bei einer vorteilhaften Ausgestaltung ist im Oberflächenabschnitt eine Gewindebohrung angeordnet, deren Mittelachse parallel zu einer Normalenrichtung des Oberflächenabschnitts ausgerichtet ist,
wobei sich als Stege Radialstege in radialer Richtung vom Oberflächenabschnitt weg erstrecken,
insbesondere wobei die Querstege in Umfangsrichtung verlaufen, also einen vom Umfangswinkel unabhängigen Radialabstand aufweisen. Von Vorteil ist dabei, dass eine möglichst gleichmäßig hohe Anpresskraft des wärmeerzeugenden Bauteils erreichbar ist im Bereich der Kontaktfläche. Somit ist ein hoher Wärmstrom gleichmäßig verteilt in den Oberflächenabschnitt einbringbar.

Bei einer vorteilhaften Ausgestaltung sind die Radialstege in Umfangsrichtung voneinander regelmäßig beabstandet. Von Vorteil ist dabei, dass eine einfach herstellbar Struktur erreichbar ist und bei der Gießherstellung des Gehäuseteils die Lunkerbildung verminderbar oder verhinderbar ist.

Bei einer vorteilhaften Ausgestaltung sind die Querstege in radialer Richtung voneinander regelmäßig beabstandet. Von Vorteil ist dabei, dass die Lunkerbildung beim Gießen verhinderbar oder verminderbar ist. Außerdem ist die Struktur der Stege einfach herstellbar und spreizt den Wärmestrom effektiv auf.

Bei einer vorteilhaften Ausgestaltung ist das wärmeerzeugende Bauteil mittels einer in die Gewindebohrung eingeschraubten Schraube verbunden mit dem Gehäuseteil, insbesondere wobei das wärmeerzeugende Bauteil angedrückt wird an den Oberflächenabschnitt. Von Vorteil ist dabei, dass eine gut wärmeleitende Verbindung durch gleichmäßig starkes Andrücken erzeugbar ist, insbesondere unter Zwischenordnung von Wärmeleitpaste.

Bei einer vorteilhaften Ausgestaltung ist das wärmeerzeugende Bauteil elektrisch mit Leiterbahnen einer Leiterplatte verbunden, welche mittels Schrauben ans Gehäuseteil angeschraubt ist. Von Vorteil ist dabei, dass die Elektronik auf einer einzigen Leiterplatte anordenbar ist. Insbesondere ist auf der Leiterplatte die Signalelektronik und die ein Leistungsmodul als Wärmeerzeugendes Bauteil umfassende Leistungselektronik eines Umrichters anordenbar. Vorzugswiese wird das Gehäuseteil auf ein weiteres Gehäuseteil aufgesetzt, das ein Elektromotorgehäuse ist.

Bei einer vorteilhaften Ausgestaltung ist die Leiterplatte mit weiteren Bauteilen, die Wärme erzeugen, zumindest auf der von der Innenseite des Gehäuseteils abgewandten Seite der Leiterplatte bestückt. Von Vorteil ist dabei, dass auch die dort erzeugte Wärme über das Gehäuseteil abführbar ist.

Bei einer vorteilhaften Ausgestaltung ist das Gehäuseteil wannenartig oder haubenartig geformt und die Stege sind am Innenboden der Wanne beziehungsweise Haube angeordnet. Von Vorteil ist dabei, dass die Seitenwände zum Abführen der Wärme der weiteren Bauteile verwendbar ist.

Bei einer vorteilhaften Ausgestaltung wird die Wärme der weiteren Bauteile über die im vom Gehäuseteil zumindest teilweise eingeschlossene Luft des Innenraumbereichs des Elektrogeräts zu den Seitenwänden der Wanne beziehungsweise Haube geführt, insbesondere wobei eine Luftströmung konvektiv angetrieben wird. Von Vorteil ist dabei, dass über die konvektiv angetriebene Luft eine Entwärmung erreichbar ist, wobei allerdings die Wärme hierbei viel schlechter aufgespreizt wird als bei der Aufspreizung der Wärme des Leistungsmoduls, also des wärmeerzeugenden Bauteils.

Bei einer vorteilhaften Ausgestaltung ist das Gehäuseteil mit einem weiteren Gehäuseteil des Elektrogeräts verbunden, wobei eine Dichtung, also Wärmesperre, zwischengeordnet ist. Von Vorteil ist dabei, dass die Elektronik des Elektrogeräts separat zum Motor entwärmbar ist.

Bei einer vorteilhaften Ausgestaltung weist das Gehäuseteil Zentrierstifte auf zum Ausrichten des Gehäuseteils relativ zum weiteren Gehäuseteil beim Aufsetzen und Verbinden. Von Vorteil ist dabei, dass ein Verkanten beim Aufsetzen vermeidbar ist und somit eine wohldefinierte Verbindung erreichbar ist.

Bei einer vorteilhaften Ausgestaltung ist die Wandstärke des Gehäuseteils im Bereich der Stege verdickt ausgeführt,
indem im Zwischenbereich der Stege die Wandstärke kleiner ist als im Bereich der Stege. Von Vorteil ist dabei, dass eine effektive Aufspreizung der Wärme erreichbar ist.

Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von Abbildungen näher erläutert:

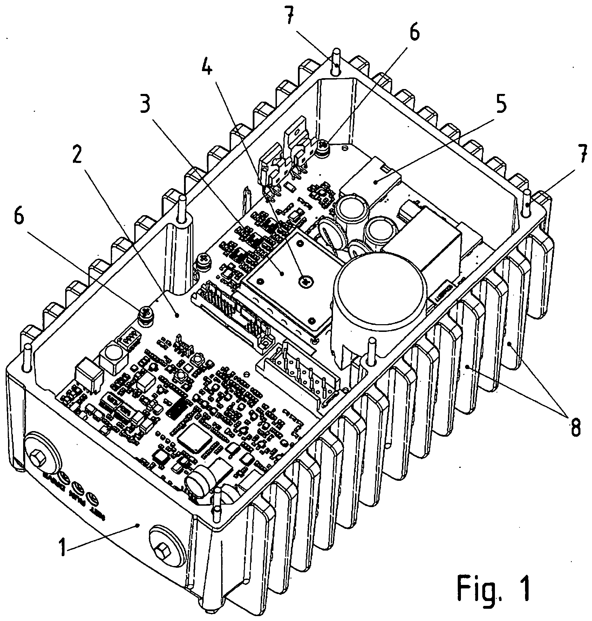

In der Figur 1 ist eine Schrägansicht auf die Innenseite eines erfindungsgemäßen eine Leiterplatte 2 aufnehmenden Gehäuseteils 1 gezeigt.

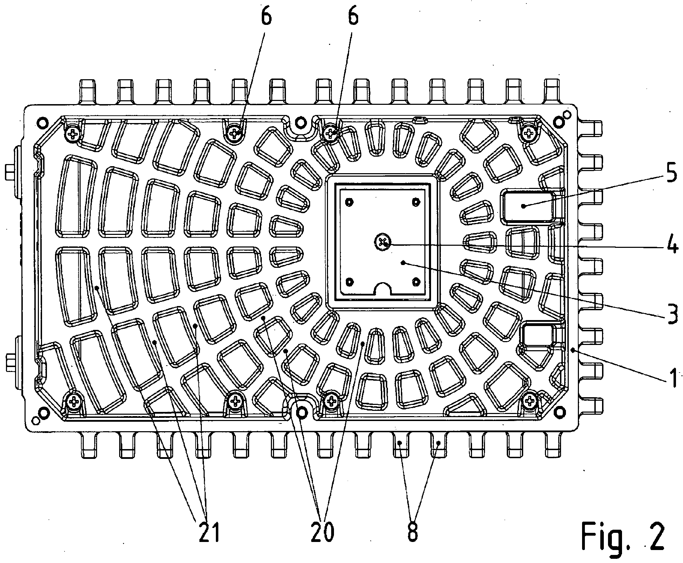

In der Figur 2 zeigt eine ist eine zugehörige Draufsicht, wobei die Leiterplatte 2 ausgeblendet ist samt ihrer Bestückung, wobei das mit Leiterbahnen der Leiterplatte 2 verbundene Leistungsmodul 3 dargestellt ist.

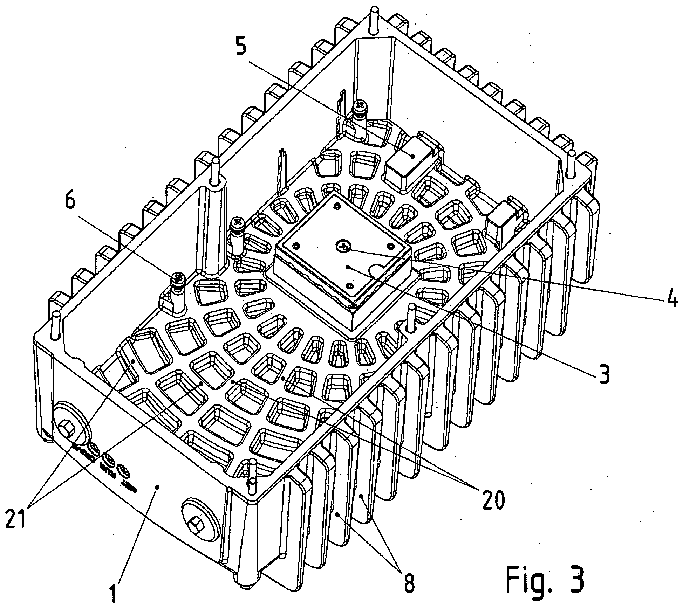

In der Figur 3 ist eine zur Figur 2 gehörige Schrägansicht gezeigt.

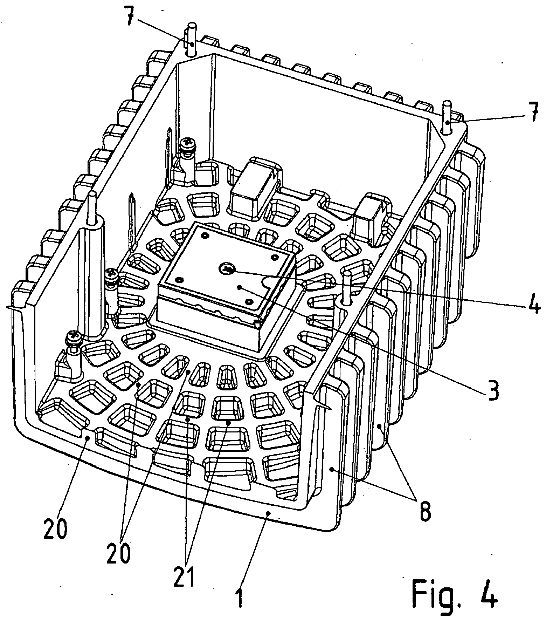

In der Figur 4 ist eine zur Figur 2 oder 3 gehörige Schrägansicht gezeigt, wobei das Gehäuseteil 1 angeschnitten ist.

Wie in den Figuren gezeigt, ist das Gehäuseteil 1 als Deckelteil ausgeführt, welches auf einem nicht dargestellten Unterteil, insbesondere Motorgehäuse, aufsetzbar ist. Dabei werden die am Gehäuseteil 1 ausgeformten Zentrierstifte 7 in entsprechende Zentrierbohrungen, insbesondere konisch ausgeführte Zentrierbohrungen, eingeführt und somit ein geführtes und zentriertes Verbinden ermöglicht. Zwischen Deckelteil und Unterteil ist eine Dichtung vorsehbar, so dass nach Verbinden des Gehäuseteils 1 mit dem Unterteil ein Gerät in hoher Schutzart gebildet ist.

An der Innenseite des haubenartig ausgeführten Deckelteils 1 ist eine mit Bauteilen bestückte Leiterplatte 2 angeordnet und mittels Schrauben 6 schraubverbunden mit dem Deckelteil 1, wobei der jeweilige Schraubenkopf der Schrauben die vom Deckelteil 1 abgewandten Seite der Leiterplatte 2 gegen das Deckelteil 1 drückt.

Das Deckelteil 1 weist an seiner Außenseite Kühlrippen 8 auf. Alternativ oder zusätzlich sind auch Kühlfinger anstatt der Kühlrippen 8 vorsehbar.

Die Leiterplatte 2 ist mit elektronischen Bauelementen bestückt, die Wärme erzeugen. Insbesondere ist auch ein Leistungsmodul, welches Leistungshalbleiterschalter aufweist, mit Leiterbahnen der Leiterplatte 2 verbunden. Das Leistungsmodul 3 ist an einem fein bearbeiteten Oberflächenabschnitt der Innenseite des Deckelteils 1 aufgesetzt. An dieser Kontaktfläche ist somit die vom Leistungsmodul 3 erzeugte Wärme ans Deckelteil abführbar. Für einen guten Wärmeübergang, also einen niedrigen Wärmeübergangswiderstand vom Leistungsmodul 3 zum Deckelteil, ist auch zwischen dem Leistungsmodul 3 und dem Deckelteil 1 Wärmeleitpaste vorsehbar. Außerdem wird das Leistungsmodul 3 mittels der Schraube 4 angeschraubt an das Deckelteil 1. Vom Schraubenkopf der Schraube 4 wird das Leistungsmodul auf das Deckelteil 1 gedrückt, so dass ein guter Wärmekontakt erreichbar ist, also ein niedriger Wärmeübergangswiderstand.

Von dieser Kontaktfläche aus erstrecken sich Radialstege 20, wobei die Radialstege 20 strahlenförmig, also geradlinig, vom Mittelpunkt des Oberflächenabschnittes aus gerichtet sind. Die Erstreckungsrichtung der Radialstege 20 ist also geradlinig vom Mittelpunkt aus, wobei die Radialstege 20 am Rand des Oberflächenabschnitts beginnen und sich radial soweit erstrecken, bis sie auf die Seitenwand des Deckelteils 1 treffen.

Im Mittelpunkt des Oberflächenabschnitts ist eine Gewindebohrung zur Aufnahme der Schraube 4 angeordnet, so dass die Schraubenachse beziehungsweise Gewindebohrungsmittelachse parallel zur Normalenrichtung des eben ausgeführten Oberflächenabschnitts ausgerichtet ist.

Die Radialstege 20 sind in Umfangsrichtung zur Mittelachse der Gewindebohrung regelmäßig voneinander beabstandet.

Außerdem sind in Umfangsrichtung sich erstreckende Querstege 21 an der Innenseite des Deckelteils vorhanden, wobei die Querstege in radialer Richtung regelmäßig voneinander beabstandet sind.

Die Radialstege 20 und die Querstege 21 sind als Verdickungen, also räumliche Bereiche verdickter Wandstärke, des Deckelteils 1 ausgeführt und ragen daher aus der Innenseite des Deckelteils 1 hervor.

Auf diese Weise ist ein Aufspreizen des vom Leistungsmodul an der Kontaktfläche, also dem Oberflächenabschnitt, ins Deckelteil 1 eingetragenen Wärmestroms erreichbar, wobei nur ein geringer Materialaufwand notwendig ist und somit der Materialverbrauch verringerbar ist. Der Oberflächenabschnitt ist im Wesentlichen rechteckförmig ausgeführt und ragt entsprechend einem flachen Dom aus der Innenseite des Deckelteils 1 heraus.

Somit ragen die Stege (20, 21) und der als Oberflächenabschnitt, also Kontaktfläche, fungierende Dom im Wesentlichen gleich weit aus der Innenseite des Deckelteils 1 heraus beziehungswiese gleich weit in den vom Deckelteil abgedeckten Innenraumbereich hinein.

Bei weiteren erfindungsgemäßen Ausführungsbeispielen sind keine Querstege 21 vorhanden und/oder die Beabstandung der Radialstege ist unregelmäßig. Weiter alternativ sind auch nicht geradlinig verlaufende Stege verwendbar, wobei die Stege derart verlaufen, dass der Abstand zum Oberflächenabschnitt entlang des Stegs sich erhöht. Außerdem ist auch ein Entfallen der Gewindebohrung und zugehörigen Schraube 4 ausführbar, wobei dann das Leistungsmodul auf andere Weise, beispielsweise durch von Federelementen erzeugte Anpresskräfte, mit dem Deckelteil verbunden ist.

An der Innenseite des Deckelteils 1 ist auch ein quaderförmiger Vorsprung 5 angeordnet, der wie auch die Stege in den vom Deckelteil abgedeckten Innenraumbereich hineinragt. Die Leiterplatte 2 weist eine entsprechende Aussparung auf, so dass der quaderförmige Vorsprung 5 durch die Aussparung hindurchragt.

### Bezugszeichenliste

- 1: Gehäuseteil
- 2: Leiterplatte
- 3: Leistungsmodul
- 4: Befestigungsschraube
- 5: quaderförmiger Vorsprung
- 6: Schraube
- 7: Zentrierstift
- 8: Kühlrippen
- 20: Radialsteg
- 21: Quersteg

## Patentansprüche

1. Elektrogerät mit Gehäuseteil (1),
wobei ein wärmeerzeugendes Bauteil an einem Oberflächenabschnitt der Innenseite des Gehäuseteils (1) angeordnet ist, insbesondere wärmeleitend verbunden ist,
wobei an der Innenseite des Gehäuseteils (1) herausragende Stege ausgeformt sind,
wobei die Stege vom Oberflächenabschnitt ausgehend sich an der Innenseite des Gehäuseteils (1) erstrecken,
insbesondere wobei die Stege in den vom Gehäuseteil (1) zumindest teilweise abgedeckten Innenraumbereich des Elektrogeräts hineinragen,
**wobei als Stege Radialstege (20) und Querstege (21) vorhanden sind, wobei die Radialstege (20) in radialer Richtung von einer Geraden aus gerichtet sind, welche in Normalenrichtung des Oberflächenabschnitts an einem Punkt des Oberflächenabschnitts ausgerichtet ist,**
**wobei die Radiälstege (20) und die Querstege (21) jeweils als Verdickungen, also räumliche Bereiche verdickter Wandstärke, des Gehäuseteils (1) ausgeführt sind und aus der Innenseite des Gehäuseteils (1) hervorragen.**

2. Elektrogerät nach mindestens einem der vorangegangenen Ansprüche,
**dadurch gekennzeichnet, dass**
das Gehäuseteil (1) an seiner Außenseite Kühlrippen (8) und/oder Kühlfinger, aufweist.

3. Elektrogerät nach mindestens einem der vorangegangenen Ansprüche,
**dadurch gekennzeichnet, dass**
der Oberflächenabschnitt an der Innenseite des Gehäuseteils (1) herausragt.

4. Elektrogerät nach mindestens einem der vorangegangenen Ansprüche,
**dadurch gekennzeichnet, dass**
die Querstege (21) in Umfangsrichtung verlaufen, also einen vom Umfangswinkel unabhängigen Radialabstand aufweisen.

5. Elektrogerät nach mindestens einem der vorangegangenen Ansprüche,
**dadurch gekennzeichnet, dass**
im Oberflächenabschnitt eine Gewindebohrung angeordnet ist, deren Mittelachse parallel zu einer Normalenrichtung des Oberflächenabschnitts ausgerichtet ist,
wobei sich als Stege Radialstege (20) in radialer Richtung vom Oberflächenabschnitt weg erstrecken,
insbesondere wobei die Querstege (21) in Umfangsrichtung verlaufen, also einen vom Umfangswinkel unabhängigen Radialabstand aufweisen.

6. Elektrogerät nach mindestens einem der vorangegangenen Ansprüche,
**dadurch gekennzeichnet, dass**
die Radialstege (20) in Umfangsrichtung voneinander regelmäßig beabstandet sind.

7. Elektrogerät nach mindestens einem der vorangegangenen Ansprüche,
**dadurch gekennzeichnet, dass**
die Querstege (21) in radialer Richtung voneinander regelmäßig beabstandet sind.

8. Elektrogerät nach mindestens einem der vorangegangenen Ansprüche,
**dadurch gekennzeichnet, dass**
das wärmeerzeugende Bauteil mittels einer in die Gewindebohrung eingeschraubten Schraube verbunden ist mit dem Gehäuseteil (1), insbesondere wobei das wärmeerzeugende Bauteil angedrückt wird an den Oberflächenabschnitt.

9. Elektrogerät nach mindestens einem der vorangegangenen Ansprüche,
**dadurch gekennzeichnet, dass**
das wärmeerzeugende Bauteil elektrisch mit Leiterbahnen einer Leiterplatte (2) verbunden ist, welche mittels Schrauben ans Gehäuseteil (1) angeschraubt ist,

10. Elektrogerät nach mindestens einem der vorangegangenen Ansprüche,
**dadurch gekennzeichnet, dass**
die Leiterplatte (2) mit weiteren Bauteilen, die Wärme erzeugen, zumindest auf der von der Innenseite des Gehäuseteils (1) abgewandten Seite der Leiterplatte (2) bestückt ist.

11. Elektrogerät nach mindestens einem der vorangegangenen Ansprüche,
**dadurch gekennzeichnet, dass**
das Gehäuseteil (1) wannenartig oder haubenartig geformt ist und die Stege am Innenboden der Wanne beziehungsweise Haube angeordnet sind.

12. Elektrogerät nach mindestens einem der vorangegangenen Ansprüche,
**dadurch gekennzeichnet, dass**
die Wärme der weiteren Bauteile über die im vom Gehäuseteil (1) zumindest teilweise eingeschlossene Luft des Innenraumbereichs des Elektrogeräts zu den Seitenwänden der Wanne beziehungsweise Haube geführt wird, insbesondere wobei eine Luftströmung konvektiv angetrieben wird.

13. Elektrogerät nach mindestens einem der vorangegangenen Ansprüche,
**dadurch gekennzeichnet, dass**
das Gehäuseteil (1) mit einem weiteren Gehäuseteil (1) des Elektrogeräts verbunden ist, wobei eine Dichtung, also Wärmesperre, zwischengeordnet ist.

14. Elektrogerät nach mindestens einem der vorangegangenen Ansprüche,
**dadurch gekennzeichnet, dass**
das Gehäuseteil (1) Zentrierstifte (7) aufweist zum Ausrichten des Gehäuseteils (1) relativ zum weiteren Gehäuseteil (1) beim Aufsetzen und Verbinden.

15. Elektrogerät nach mindestens einem der vorangegangenen Ansprüche,
**dadurch gekennzeichnet, dass**
die Wandstärke des Gehäuseteils (1) im Bereich der Stege verdickt ausgeführt ist,
indem im Zwischenbereich der Stege die Wandstärke kleiner ist als im Bereich der Stege.

## Claims

1. Electrical appliance with housing part (1),
wherein a heat-generating component is arranged on a surface section of the inside of the housing part (1), in particular is connected in a heat-conducting manner,
wherein protruding webs are formed on the inside of the housing part (1),
wherein the webs extend starting from the surface section on the inside of the housing part (1),
in particular wherein the webs protrude into the at least partially covered interior region of the electrical appliance,
wherein as the webs radial webs (20) and transverse webs (21) are provided, wherein the radial webs (20) are directed in the radial direction from a straight line which is oriented in the direction of the normal to the surface section at a point of the surface section,
wherein the radial webs (20) and the transverse webs (21) are each designed as thickenings, that is to say spatial regions of thickened wall thickness, of the housing part (1) and protrude from the inside of the housing part (1).

2. Electrical appliance according to at least one of the preceding claims,
**characterised in that**
the housing part (1) has on its outside cooling ribs (8) and/or cooling fingers.

3. Electrical appliance according to at least one of the preceding claims,
**characterised in that**
the surface section protrudes on the inside of the housing part (1).

4. Electrical appliance according to at least one of the preceding claims,
**characterised in that**
the transverse webs (21) run in the circumferential direction, that is to say are at a radial distance independent of the circumferential angle.

5. Electrical appliance according to at least one of the preceding claims,
**characterised in that**
in the surface section there is arranged a threaded hole, the centre axis of which is oriented parallel to a direction of the normal to the surface section,
wherein as the webs, radial webs (20) extend in the radial direction away from the surface section,
in particular wherein the transverse webs (21) run in the circumferential direction, that is to say are at a radial distance independent of the circumferential angle.

6. Electrical appliance according to at least one of the preceding claims,
**characterised in that**
the radial webs (20) are spaced regularly from one another in the circumferential direction.

7. Electrical appliance according to at least one of the preceding claims,
**characterised in that**
the transverse webs (21) are spaced regularly from one another in the radial direction.

8. Electrical appliance according to at least one of the preceding claims,
**characterised in that**
the heat-generating component is connected to the housing part (1) by means of a screw screwed into the threaded hole, in particular wherein the heat-generating component is pressed onto the surface section.

9. Electrical appliance according to at least one of the preceding claims,
**characterised in that**
the heat-generating component is electrically connected to conductor tracks of a printed circuit board (2), which is screwed onto the housing part (1) by means of screws.

10. Electrical appliance according to at least one of the preceding claims,
**characterised in that**
the printed circuit board (2) is fitted with further components, which generate heat, at least on the side of the printed circuit board (2) facing away from the inside of the housing part (1).

11. Electrical appliance according to at least one of the preceding claims,
**characterised in that**
the housing part (1) is of tub-like or hood-like shape and the webs are arranged on the inner bottom of the tub or hood, respectively.

12. Electrical appliance according to at least one of the preceding claims,
**characterised in that**
the heat of the further components is led via the air of the interior region of the electrical appliance, which air is at least partially enclosed by the housing part (1), to the side walls of the tub or hood, respectively, in particular wherein an air flow is convectively driven.

13. Electrical appliance according to at least one of the preceding claims,
**characterised in that**
the housing part (1) is connected to a further housing part (1) of the electrical appliance, wherein a seal, that is to say heat barrier, is interposed.

14. Electrical appliance according to at least one of the preceding claims,
**characterised in that**
the housing part (1) has centring pins (7) for aligning the housing part (1) relative to the further housing part (1) on mounting and connection.

15. Electrical appliance according to at least one of the preceding claims,
**characterised in that**
the wall thickness of the housing part (1) is of thickened design in the region of the webs,
since in the intermediate region of the webs the wall thickness is less than in the region of the webs.

## Revendications

1. Appareil électrique comprenant une partie boîtier (1),
un composant générateur de chaleur étant disposé sur une section de surface du côté intérieur de la partie boîtier (1), en particulier relié à celle-ci de manière thermo-conductrice,
des nervures en saillie étant formées sur le côté intérieur de la partie boîtier (1),
les nervures s'étendant à partir de la section de surface sur le côté intérieur de la partie boîtier (1),
en particulier les nervures pénétrant dans l'espace intérieur de l'appareil électrique qui est recouvert au moins en partie par la partie boîtier (1),
des nervures radiales (20) et des nervures transversales (21) étant présentes en tant que nervures, les nervures radiales (20) étant dirigées en direction radiale à partir d'une droite qui est orientée dans la direction normale à la section de surface en un point de la section de surface,
les nervures radiales (20) et les nervures transversales (21) étant réalisées chaque fois sous la forme d'épaississements, donc de zones spatiales de plus forte épaisseur de paroi de la partie boîtier (1) et faisant saillie du côté intérieur de la partie boîtier (1).

2. Appareil électrique selon au moins l'une des revendications précédentes,
**caractérisé en ce que**
la partie boîtier (1) présente des ailettes de refroidissement (8) et/ou des doigts de refroidissement sur son côté extérieur.

3. Appareil électrique selon au moins l'une des revendications précédentes,
**caractérisé en ce que**
la section de surface est en saillie sur le côté intérieur de la partie boîtier (1).

4. Appareil électrique selon au moins l'une des revendications précédentes,
**caractérisé en ce que**
les nervures transversales (21) s'étendent en direction circonférentielle, donc présentent une distance radiale indépendante de l'angle circonférentiel.

5. Appareil électrique selon au moins l'une des revendications précédentes,
**caractérisé en ce que**
un trou fileté est disposé dans la section de surface, dont l'axe médian est orienté parallèlement à une direction normale à la section de surface,
des nervures radiales (20) s'étendant en direction radiale à partir de la section de surface,
en particulier, les nervures transversales (21) s'étendant en direction circonférentielle, donc présentant une distance radiale indépendante de l'angle circonférentiel.

6. Appareil électrique selon au moins l'une des revendications précédentes,
**caractérisé en ce que**
les nervures radiales (20) sont espacées les unes des autres régulièrement en direction circonférentielle.

7. Appareil électrique selon au moins l'une des revendications précédentes,
**caractérisé en ce que**
les nervures transversales (21) sont espacées les unes des autres régulièrement en direction radiale.

8. Appareil électrique selon au moins l'une des revendications précédentes,
**caractérisé en ce que**
le composant générateur de chaleur est relié à la partie boîtier (1) au moyen d'une vis insérée dans le trou fileté, le composant générateur de chaleur étant en particulier pressé contre la section de surface.

9. Appareil électrique selon au moins l'une des revendications précédentes,
**caractérisé en ce que**
le composant générateur de chaleur est relié électriquement à des pistes conductrices d'une carte de circuits imprimés (2) qui est vissée à la partie boîtier (1) au moyen de vis.

10. Appareil électrique selon au moins l'une des revendications précédentes,
**caractérisé en ce que**
la carte de circuits imprimés (2) est équipée d'autres composants qui produisent de la chaleur, au moins sur le côté de la carte de circuits imprimés (2) opposé au côté intérieur de la partie boîtier (1).

11. Appareil électrique selon au moins l'une des revendications précédentes,
**caractérisé en ce que**
la partie boîtier (1) est réalisée en forme de cuvette ou de calotte et les nervures sont disposées sur le fond intérieur de la cuvette ou de la calotte.

12. Appareil électrique selon au moins l'une des revendications précédentes,
**caractérisé en ce que**
la chaleur des autres composants est conduite par l'air de l'espace intérieur de l'appareil électrique, enfermé au moins partiellement par la partie boîtier (1), vers les parois latérales de la cuvette ou de la calotte, en particulier une circulation d'air étant entraînée par convection.

13. Appareil électrique selon au moins l'une des revendications précédentes,
**caractérisé en ce que**
la partie boîtier (1) est reliée à une autre partie boîtier (1) de l'appareil électrique, un joint, donc une barrière athermique, étant disposé entre les deux.

14. Appareil électrique selon au moins l'une des revendications précédentes,
**caractérisé en ce que**
la partie boîtier (1) présente des broches de centrage (7) pour aligner la partie boîtier (1) par rapport à l'autre partie boîtier (1) lors de la pose et de la liaison.

15. Appareil électrique selon au moins l'une des revendications précédentes,
**caractérisé en ce que**
l'épaisseur de paroi de la partie boîtier (1) est plus forte dans la zone des nervures,
l'épaisseur de paroi étant plus faible dans la zone intermédiaire des nervures que dans la zone des nervures.
